# EUROPÄISCHE PATENTSCHRIFT

(11) **EP 0 584 599 B1**
(45) Veröffentlichungstag und Bekanntmachung des Hinweises auf die Patenterteilung: **03.06.1998**
(21) Anmeldenummer: 93112506.6
(22) Anmeldetag: 04.08.1993
(51) Int. Cl.: H01L 33/00

(54) **Leuchtdiode**
Light-emitting diode
Diode photoémettrice

(30) Priorität: 28.08.1992 DE 4228758
(43) Veröffentlichungstag der Anmeldung: 02.03.1994
(73) Patentinhaber: SIEMENS AKTIENGESELLSCHAFT, 80333 München (DE)
(72) Erfinder: Neumann, Gerald, Dipl.-Phys., D-93051 Regensburg (DE); Nirschl, Ernst, Dr. rer. nat., Dipl.-Phys., D-93173 Wenzenbach (DE); Späth, Werner, Dipl.-Phys., D-83607 Holzkirchen (DE)

(56) Entgegenhaltungen:
- EP-A- 0 102 734
- DE-A- 3 200 788
- PATENT ABSTRACTS OF JAPAN vol. 4, no. 112 (E-21)12. August 1980 & JP-A-55 071 080 (TOSHIBA CORP) 28. Mai 1980
- PATENT ABSTRACTS OF JAPAN vol. 3, no. 92 (E-128)4. August 1979 & JP-A-54 069 975 (TOSHIBA CORP) 5. Juni 1979
- PATENT ABSTRACTS OF JAPAN vol. 3, no. 92 (E-128)4. August 1979 & JP-A-54 069 979 (TOSHIBA CORP) 5. Juni 1979

## Beschreibung

Die Erfindung betrifft eine Leuchtdiode nach dem Oberbegriff des Patentanspruchs 1.

Leuchtdioden (lichtemittierende Dioden, LED) sind Halbleiter- bzw. Lumineszenzdioden, die bei Stromfluß in Durchlaßrichtung Licht im sichtbaren Spektralbereich aussenden.

Zur Herstellung rein grünleuchtender Leuchtdioden (LEDS) wird bekanntlich ein Galliumphosphid-Halbleitersubstrat verwendet. Die Schichtenfolge zum Erzeugen des lichtaktiven pn-Übergangs kann mittels Gasphasenepitaxie oder Flüssigphasenepitaxie hergestellt werden. Letztere Methode ermöglicht einen höheren Wirkungsgrad der Leuchtdiode.

Leuchtdioden der eingangs genannten Art sind beispielsweise aus JP-A-54-69979 und JP-A-54-69975 bekannt.

Andere bekannte grünleuchtende LEDs bestehen aus GaP-Epitaxiescheiben, die mit solcher Reinheit und Dotierung hergestellt werden, daß sie auf Scheibenebene zu einer Lichtemission in dem gewünschten grünen Spektralbereich führen. Um sogenannte pure-green-leuchtende Dioden (Dominantwellenlänge ca. 557±4nm) herzustellen, wird bei dem Epitaxieverfahren auf Stickstoffeinbau verzichtet, obwohl dadurch der Wirkungsgrad der LED sinkt. Die p-dotierte Scheibenseite ist dabei zum Teil, d.h. in einem vorgegebenen Oberflächenbereich, mit einer Gold-Beryllium-Kontaktierung als der eine der beiden Diodenkontakte versehen. Beryllium ist allerdings krebserregend und extrem giftig. Als akkumulationsfähiges Gift kann es durch Haut-, Schleimhaut- und Lungenerkrankungen tödlich wirken.

Es ist zudem bekannt, statt einer Gold-Berylliumkontaktierung als Kontaktierung der p-leitenden Scheibenseite eine Gold-Zinkkontaktierung bei grün leuchtenden Leuchtdioden vorzusehen. Bei derartig kontaktierten Leuchtdioden tritt allerdings eine unerwünschte Rotemission auf.

Der Erfindung liegt die Aufgabe zugrunde, bei einer Leuchtdiode der eingangs genannten Art diese Nachteile zu vermeiden und eine Leuchtdiode zu schaffen, die eine Erzeugung von rein grünem Licht mit hoher Ausbeute ermöglicht.

Diese Aufgabe wird erfindungsgemäß mit den Merkmalen des Patentanspruchs 1 gelöst.

Vorteilhafte Ausgestaltungen und Weiterbildungen der Erfindung sind Gegenstand zusätzlicher Ansprüche.

Bei der Erfindung wird von der Erkenntnis ausgegangen, daß beim Aufbringen der Gold-Zinkschicht, das zweckmäßig in einem Sputterprozeß erfolgt, Sauerstoff aus dem Restgas der Sputteranlage durch Zink gebunden und in die AuZn-Schicht eingebaut wird. Dieser Sauerstoff diffundiert bei nachfolgenden Temperaturschritten zum pn-Übergang und bildet dort Nachbarkomplexe mit dem zur p-Dotierung verwendeten Dotierstoff. Diese Nachbarkomplexe ermöglichen die unerwünschte Emission im roten Spektralbereich.

Die mit der Erfindung erzielten Vorteile bestehen insbesondere darin, daß durch das Anbringen einer elektrisch leitenden Schicht unter der AuZn-Schicht der Sauerstoff beim Aufbringen der Kontaktierungen bzw. den nachfolgenden Temperaturbehandlungen, d.h. beim Herstellen der Diode von einer Diffusion in den Halbleiter abgehalten wird. Als solche elektrisch leitende Schichten haben sich Schichten aus Titan oder Gold als vorteilhaft erwiesen. Die Dicke dieser Schichten ist dabei zweckmäßig so abgestimmt, daß das Zink aus der AuZn-Schicht gleichzeitig in der Lage ist, bei den Temperaturschritten diese Schichten zu durchdringen, so daß in der angrenzenden Halbleiteroberfläche eine hohe Oberflächendotierung erzeugt und somit ein guter ohmscher Kontakt ermöglicht wird.

Bei den erfindungsgemäßen Leuchtdioden tritt die durch den Chipprozeß verursachte Rotemission, die zu einer Verschiebung der Dominantwellenlänge um ca. 10nm gegenüber der angestrebten rein grünen Dominantwellenlänge von ca. 557 ± 4nm führen kann, nicht mehr auf. Die dominante Wellenlänge beschreibt dabei als anwenderfreundlicher Begriff des LED-Spektrums den Farbton einer LED, wie ihn das menschliche Auge empfindet.

Vorteilhafterweise wird bei der erfindungsgemäßen Leuchtdiode gleichzeitig eine Steigerung der Lichtausbeute erreicht. Das ist dadurch bedingt, daß ohne die beseitigten Rotübergänge mehr Strom für die Anregung im grünen Bereich, in dem die Augenempfindlichkeit deutlich größer ist, zur Verfügung steht.

Anhand von in den Figuren der Zeichnung dargestellten Ausführungsbeispielen wird die Erfindung im folgenden näher erläutert. Es zeigen
- FIG 1: eine erfindungsgemäße Leuchtdiode im Schnitt und
- FIG 2: eine Ausführungsform einer Leuchtdiode im Schnitt zur Illustration.

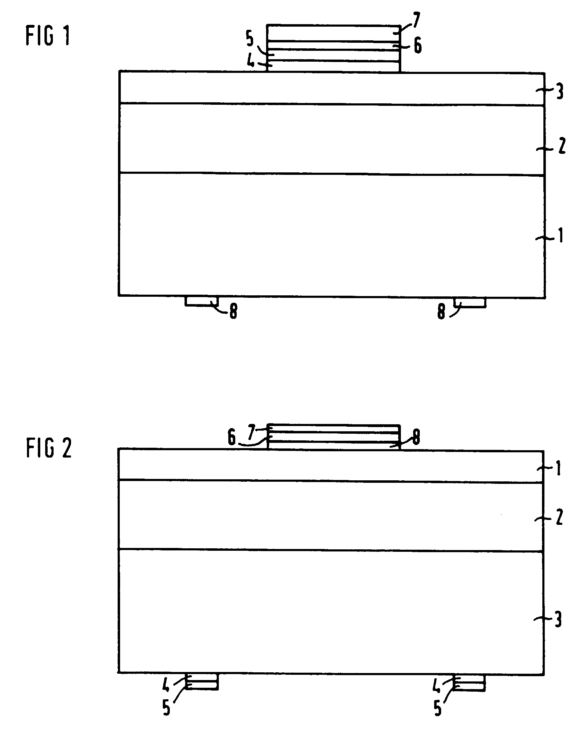

Die in FIG 1 dargestellte Leuchtdiode besteht aus einem Chip aus vorzugsweise Galliumphosphid als Halbleitermaterial. Dabei ist auf die n-leitende Scheibenseite 1, in diesem Beispiel auf das n-leitende GaP-Substrat, das beispielsweise Te- oder S-dotiert ist, als erste Epitaxieschicht 2 eine n-leitende Schicht, d.n. eine wiederum beispielsweise Te- oder S-dotierte Schicht epitaktisch aufgebracht. Als Epitaxie-Verfahren kommen sowohl Gasphasen- als auch vorzugsweise Flüssigphasenepitaxie in Frage. Auf die erste Epitaxieschicht 2 ist eine p-leitende, vorzugsweise Zink-dotierte Schicht epitaktisch aufgebracht, welche in diesem Ausführungsbeispiel die p-leitende Scheibenseite 3 der Leuchtdiode bildet.

Diese Epi-Scheibe (Wafer) wird nun auf der Oberfläche der p-leitenden Scheibenseite 3 in einem vorgegebenen Teilbereich mit einer Zink-dotierten Kontaktierung 5 versehen. Zwischen Zink-dotierter Kontaktierung 5 und p-leitender Scheibenseite 3 ist eine elektrisch leitende Schicht 4 vorgesehen, die vorzugsweise aus Gold oder Titan besteht und beim Herstellen der Diode, d.n. beim Aufbringen der Kontaktierungen bzw. den nachfolgenden Temperaturbehandlungen eine Diffusion von Sauerstoff in die p-leitende Scheibenseite 3 verhindert.

Die Dicke der elektrisch leitenden Schicht 4 ist so bemessen, daß Zink aus der Zink-dotierten Kontaktierung 5, vorzugsweise einer Gold-Zinkschicht, beim Fertigstellen der Diode diese Schicht durchdringt und eine hohe Oberflächendotierung erzeugt. Eine hohe Oberflächendotierung nat den erwünschten guten ohmschen Kontakt zur Folge. Zum späteren Montieren der fertigen Leuchtdiode können die Kontaktierungen mit einer Metallschicht 7, beispielsweise aus Gold oder Aluminium versehen werden. Dabei haben wegen ihrer besseren Montierbarkeit Aluminiumkontakte den Vorzug. Zwischen Metallschicht 7 und Zink-Goldschicht 5 ist in diesem Ausführungsbeispiel als Diffusionssperre eine Titan-Wolfram-Nitridschicht 6 vorgesehen. Als Metallisierung 8 für die n-leitende Scheibenseite der Leuchtdiode werden beispielsweise Gold-Germaniumkontaktierungen verwendet.

Während die in FIG 1 dargestellte Leuchtdiode aus einem n-leitenden GaP-Substrat als n-leitende Scheibenseite 1, einer n-leitenden Schicht als erste Epitaxieschicht 2 und einer Zink-dotierten Epitaxieschicht als p-leitende Scheibenseite 3 gebildet ist, besteht die Leuchtdiode gemäß FIG 2 aus einem p-leitenden, vorzugsweise Zink-dotierten Galliumphosphid-Substrat, welches in diesem illustrierenden Beispiel die p-leitende Scheibenseite 3 bildet. Auf die p-leitende Scheibenseite 3 (GaP-Substrat) ist als erste Epitaxieschicht 2 in diesem Beispiel demnach eine p-leitende Schicht aufgebracht, die zweckmäßig Zink-dotiert ist. Als zweite Epitaxieschicht bzw. n-leitende Scheibenseite 1 befindet sich auf der in diesem Beispiel p-leitenden ersten Epitaxieschicht 2 eine n-leitende Epitaxieschicht, die ähnlich der ersten Ausfünrungsform beispielsweise mit Tellur oder Schwefel dotiert ist. Sowohl Metallisierung 8 der n-leitenden Scheibenseite 1 als auch Zink-dotierte Kontaktierung 5 der p-leitenden Scheibenseite 3 sind entsprechend dem Beispiel gemäß FIG 1 ausgeführt, wobei lediglich die Kontaktanordnung bzw. Kontaktschichtenfolge der abgewandelten Schichtenfolge der Leuchtdiode angepaßt ist. Das bedeutet, daß sich bei dem in FIG 2 dargestellten Ausführungsbeispiel die TiWN-Schicht 6 und die Metallschicht 7 auf der Metallisierung 8 statt auf der Zink-dotierten Kontaktierung 5 befinden.

## Patentansprüche

1. Leuchtdiode, bei der auf einer n-dotierten Halbleiter-Substratscheibe ein für eine Lichtemission im grünen Spektralbereich geeignete Schichtenfolge mit einer n-leitenden ersten Epitaxieschicht und und einer p-leitenden zweiten Epitaxieschicht aufgebracht ist, wobei die zweite Epitaxieschicht eine p-leitende Scheibenseite bildet, und bei der eine Oberfläche der p-leitenden Scheibenseite in einem vorgegebenen Teilbereich mit einer Zink-dotierten Kontaktierung versehen ist, wobei zwischen der Zink-dotierten Kontaktierung (5) und der p-leitenden Scheibenseite (3) eine eine Diffusion von Sauerstoff aus der Zink-dotierten Kontaktierung (5) in die p-leitende Scheibenseite (3) unterbindende elektrisch leitende Schicht (4) vorgesehen ist, deren Dicke so bemessen ist, daß beim Fertigstellen der Leuchtdiode Zink aus der Zink-dotierten Kontaktierung diese elektrisch leitende Schicht (4) durchdringt und in der p-leitenden Scheibenseite (3) eine hohe Oberflächendotierung erzeugt, **dadurch gekennzeichnet**,
daß auf einer der p-leitenden Scheibenseite (3) abgewandten Seite der Zink-dotierten Kontaktierung (5) eine Titan-Wolfram-Nitrid-Schicht (6) vorgesehen ist, auf der sich eine Metallschicht (7) befindet.

2. Leuchtdiode nach Anspruch 1,
**dadurch gekennzeichnet,**
daß die elektrisch leitende Schicht (4) eine Gold- oder Titanschicht ist.

3. Leuchtdiode nach Anspruch 1 oder 2,
**dadurch gekennzeichnet,**
daß die Zink-dotierte Kontaktierung (5) eine Gold-Zink-Schicht ist.

4. Leuchtdiode nach einem der Ansprüche 1 bis 3,
**dadurch gekennzeichnet**,
daß die Halbleiter-Substratscheibe aus Gallium-Phosphid besteht.

5. Leuchtdiode nach einem der Ansprüche 1 bis 4,
**dadurch gekennzeichnet,**
daß die p-leitende Scheibenseite (3) mit Zink dotiert ist.

## Claims

1. Light-emitting diode, in which a layer sequence that is suitable for the emission of light in the green spectral range and has an n-conducting first epitaxial layer and a p-conducting second epitaxial layer is applied to an n-doped semiconductor substrate wafer, the second epitaxial layer forming a p-conducting wafer side, and in which one surface of the p-conducting wafer side is provided with a zinc-doped contact in a predetermined subregion, wherein, between the zinc-doped contact (5) and the p-conducting wafer side (3), an electrically conducting layer (4) which stops the diffusion of oxygen from the zinc-doped contact (5) into the p-conducting wafer side (3), is provided, with a thickness such that, when the light-emitting diode is fabricated, zinc from the zinc-doped contact penetrates this electrically conducting layer (4) and produces a high degree of surface doping in the p-conducting wafer side (3), characterized in that a titanium tungsten nitride layer (6), on which there is a metal layer (7), is provided on the opposite side of the zinc-doped contact (5) from the p-conducting wafer side (3).

2. Light-emitting diode according to Claim 1, characterized in that the electrically conducting layer (4) is a gold or titanium layer.

3. Light-emitting diode according to Claim 1 or 2, characterized in that the zinc-doped contact (5) is a gold/zinc layer.

4. Light-emitting diode according to one of Claims 1 to 3, characterized in that the semiconductor substrate wafer consists of gallium phosphide.

5. Light-emitting diode according to one of Claims 1 to 4, characterized in that the p-conducting wafer side (3) is doped with zinc.

## Revendications

1. Diode photoémettrice, dans laquelle sur une plaquette de substrat semi-conductrice dopée n est appliquée une stratification appropriée pour une émission lumineuse dans une zone spectrale verte avec une première couche épitaxiale conductrice n et une deuxième couche épitaxiale conductrice p, la deuxième couche épitaxiale formant un côté de plaquette conducteur p, et dans laquelle une surface du côté de plaquette conducteur p est pourvue d'un bonding dopé au zinc dans une zone partielle prédéfinie, dans laquelle entre le bonding dopé au zinc (5) et le côté de plaquette conducteur p (3) est prévue une couche électriquement conductrice (4) entravant une diffusion d'oxygène provenant du bonding dopé au zinc (5) dans le côté de plaquette conducteur p (3), l'épaisseur de ladite couche étant calculée de manière à ce que lors de la fabrication de la diode photoémettrice, le zinc provenant du bonding dopé au zinc traverse cette couche électriquement conductrice (4) et crée dans le côté de plaquette conducteur p (3) un dopage superficiel élevé, caractérisée en ce qu'est prévue, sur un côté opposé au côté de plaquette conducteur p (3) du bonding dopé au zinc (5), une couche de titane-tungstène-nitrure (6), sur laquelle se trouve une couche de métal (7).

2. Diode photoémettrice selon la revendication 1, caractérisée en ce que la couche électriquement conductrice (4) est une couche d'or ou de titane.

3. Diode photoémettrice selon la revendication 1 ou 2, caractérisée en ce que le bonding dopé au zinc (5) est une couche or-zinc.

4. Diode photoémettrice selon l'une des revendications 1 à 3, caractérisée en ce que la plaquette de substrat semi-conductrice est composée de phosphure de gallium.

5. Diode photoémettrice selon l'une des revendications 1 à 4, caractérisée en ce que le côté de plaquette conducteur p (3) est dopé au zinc.
